# EUROPÄISCHE PATENTSCHRIFT

(11) **EP 0 864 099 B1**
(45) Veröffentlichungstag und Bekanntmachung des Hinweises auf die Patenterteilung: **28.08.2002**
(21) Anmeldenummer: 96945988.2
(22) Anmeldetag: 15.11.1996
(51) Int. Cl.: G01R 31/28

(54) **VERFAHREN UND EINRICHTUNG ZUR ÜBERPRÜFUNG ELEKTRISCHER ANTRIEBE**
PROCESS AND DEVICE FOR TESTING ELECTRIC DRIVES
PROCEDE ET DISPOSITIF POUR LE CONTROLE DE DISPOSITIFS ELECTRIQUES D'ENTRAINEMENT

(30) Priorität: 30.11.1995 DE 19544565
(43) Veröffentlichungstag der Anmeldung: 16.09.1998
(73) Patentinhaber: SIEMENS AKTIENGESELLSCHAFT, 80333 München (DE)
(72) Erfinder: BENKE, Harald-Peter, D-63795 Kahl (DE); HORBACH, Robert, D-63755 Alzenau (DE); KUTZER, Heinz, D-63477 Maintal (DE)
(86) Internationale Anmeldenummer: DE9602178
(87) Internationale Veröffentlichungsnummer: WO97020224

(56) Entgegenhaltungen:
- EP-A- 0 625 710
- WO-A-93/08482
- DE-A- 3 105 591
- US-A- 5 050 823

## Beschreibung

Die Erfindung betrifft ein Verfahren zur Überprüfung einer Mehrzahl elektrischer Antriebe, insbesondere von motorischen oder magnetischen Antrieben von Armaturen, Stellgliedern, Schaltschützen oder Relais, wobei an der Mehrzahl elektrischer Antriebe Meßwerte aufgenommen und diese beschreibende Signale dann einen zentralen oder übergeordneten Datenverarbeitungssystem zugeleitet werden, wo sie mit dort vorhandenen Sollwerten verglichen werden und bei einer Abweichung eines Signals von seinem Sollwert ein Fehler desjenigen Antriebes, von dem das Signal ausging, angezeigt wird.

Die Erfindung betrifft auch eine Einrichtung zur Durchführung des Verfahrens, wobei an der Mehrzahl elektrischer Antriebe zur Aufnahme von Meßwerten und Abgabe von Signalen Sensoren angeordnet sind, die mit einem zentralen oder übergeordneten Datenvearbeitungssystem verbindbar sind, das eine Vergleichsvorrichtung zum Vergleich der von den Sensoren abgegebenen Signale mit Sollwerten umfaßt und mit einer Anzeigevorrichtung verbunden ist.

Bisher war es üblich, zur Überprüfung einer Mehrzahl elektrischer Antriebe jeden dieser Antriebe einzeln zu untersuchen. Dazu wurde häufig jeder zu überprüfende Antrieb von seinem Stromkreis getrennt und nacheinander einzeln in einen separaten Prüfstromkreis eingebunden. Für die Überprüfung einer großen Anzahl elektrischer Antriebe, war also ein großer Zeitaufwand erforderlich.

Aus der EP 0 609 261 B1 ist eine Einrichtung zur Überprüfung eines elektrischen Antriebes bekannt, bei der der übliche Betrieb des Antriebes während der Überprüfung nicht unterbrochen zu werden braucht. Dazu wird jeder Antrieb einzeln über einen Diagnosestecker mit einer Auswerteeinheit verbunden. Ein Codierungsabgriff an einem Einschub des Antriebes dient nur dazu, zu erkennen, an welchem Einschub der Diagnosestekker angeschlossen ist. Mit einer Auswerteeinheit kann zur gleichen Zeit nur ein Antrieb überprüft werden. Zur gleichzeitigen Überprüfung mehrerer Antriebe sind mehrere gleichartige Ausführungen der bekannten Einrichtungen erforderlich.

Der Erfindung liegt die Aufgabe zugrunde, ein Verfahren und eine Einrichtung zur Überprüfung einer Mehrzahl elektrischer Antriebe anzugeben, die es ermöglichen, mit geringem Aufwand eine große Anzahl elektrischer Antriebe innerhalb einer kurzen Zeitspanne zu überprüfen.

Die Aufgabe, ein geeignetes Verfahren anzugeben, wird gemäß der Erfindung dadurch gelöst, daß die Signale mit antriebsspezifischen Kennzeichen versehen und ohne Unterbrechung on-line dem zentralen oder übergeordneten Datenverarbeitungssystem zugeleitet werden, wo durch das antriebsspezifische Kennzeichen ein Fehler demjenigen Antrieb zugeordnet wird, von dem das Signal ausging.

Es werden also die Signale selbst mit antriebsspezifischen Kennzeichen versehen. Dadurch kommt man vorteilhafterweise mit nur einem zentralen oder übergeordneten Datenverarbeitungssystem aus, um festzustellen, in welchem Antrieb ein Fehler aufgetreten ist. Insbesondere wird der Vorteil erzielt, daß durch die On-line-Verbindung der Sensoren aller Antriebe mit dem Datenverarbeitungssystem alle Antriebe zur gleichen Zeit überwacht werden können. Es sind keine Diagnosestecker notwendig, die von einem Antrieb zum anderen umgesteckt werden müßten.

Es wird der Vorteil erzielt, daß während alle vorhandenen Antriebe in Betrieb sein können, mit nur einem Datenverarbeitungssystem on-line erkannt werden kann, ob ein Antrieb oder mehrere Antriebe den Anforderungen nicht genügen. In einem solchen Fall ist darüber hinaus zuverlässig feststellbar, um welchen Antrieb oder um welche Antriebe es sich handelt.

Die Meßwerte werden beispielsweise von Sensoren aufgenommen, die Leistungskreisen und/oder Steuerungskreisen der Antriebe zugeordnet sind. Auf diese Weise werden Meßwerte ermittelt, die über den Zustand des betreffenden Antriebes Aufschluß geben.

Beispielsweise werden die Signale, bevor sie dem Datenverarbeitungssystem zugeleitet werden, konditioniert. Das bedeutet, daß aus den Signalen, die bestimmte physikalische Größen wiedergeben, andere physikalische Größen errechnet und als Signale bereitgestellt werden. Die Konditionierung kann digital oder analog erfolgen.

Beispielsweise werden, um mehrere Signale verknüpfen zu können, beim Konditionieren früher eintreffende Signale zwischengespeichert, um aus diesen und später eintreffenden Signalen neue Signale bilden zu können, die nicht gemessene physikalische Größen beschreiben. Da mindestens aus zwei ursprünglichen Signalen ein neues Signal bestimmt wird, wird die Anzahl der Daten, die dem zentralen oder übergeordneten Datenverarbeitungssystem zugeleitet werden müssen, vorteilhafterweise reduziert, ohne daß die Zuverlässigkeit des Verfahrens abnimmt. Beispielsweise wird nach der Konditionierung statt Spannung und Stromstärke die Wirkleistung untersucht. Es kann auch bei einer physikalischen Größe die Temperaturabhängigkeit berücksichtigt werden.

Die konditionierten Signale werden beispielsweise über ein digitales oder hybrides Netzwerk dem zentralen oder übergeordneten Datenverarbeitungssystem zugeleitet. Dadurch ist eine schnelle Übermittlung gewährleistet.

Nach einem anderen Beispiel werden die konditionierten Signale zunächst konzentriert und erst dann im Datenverarbeitungssystem der zentralen Datenverarbeitung unterzogen. Eine solche Konzentration sieht vor, daß die vorhandenen Signale nach ihrer Bedeutung unterschieden werden und daß dann nur die für eine Überprüfung der elektrischen Antriebe aussagekräftigen Signale an das zentrale oder übergeordnete Datenverarbeitungssystem weitergeleitet werden.

Damit wird der Vorteil erzielt, daß die Anzahl der Signale, die im zentralen oder übergeordneten Datenverarbeitungssystem zu bearbeiten sind, sehr klein gehalten werden kann, ohne daß die Zuverlässigkeit der Überprüfung der Antriebe leidet.

Mit dem Verfahren nach der Erfindung wird der Vorteil erzielt, daß zahlreiche Antriebe gleichzeitig on-line mit geringem technischen Aufwand zuverlässig überprüft werden können.

Die Aufgabe, eine geeignete Einrichtung zur Durchführung des Verfahrens zur Überprüfung einer Mehrzahl elektrischer Antriebe anzugeben, wird nach der Erfindung dadurch gelöst, daß die Sensoren mit antriebsspezifischen Markiervorrichtungen ausgestattet sind, die die Signale mit antriebsspezifischen Kennzeichen versehen, und daß die Sensoren on-line ohne Unterbrechung mit dem zentralen oder übergeordneten Datenverarbeitungssystem verbunden sind, in dem Signale mit Hilfe der antriebsspezifischen Kennzeichen den Sensoren zuordenbar sind.

Mit dieser Einrichtung wird der Vorteil erzielt, daß mit einem zentralen oder übergeordneten Datenverarbeitungssystem mehrere Antriebe zur selben Zeit on-line überprüft werden können, da die Signale, die von den Sensoren ausgehen, durch die Markiervorrichtungen so gekennzeichnet sind, daß sie einem Antrieb zuverlässig zugeordnet werden können.

Beispielsweise sind Sensoren über mindestens einen, z.B. digitalen oder analogen, Signalkonditionierer mit dem Datenverarbeitungssystem verbunden. Damit wird der Vorteil erzielt, daß die Anzahl der Signale, die verarbeitet werden müssen, reduziert werden kann, indem aus mindestens zwei ursprünglichen Signalen in einem Signalkonditionierer ein neues Signal errechnet wird, das mindestens genauso viele Informationen über den Zustand des Antriebs liefert, wie die ursprünglichen Signale.

Jeder Signalkonditionierer umfaßt dazu beispielsweise einen Speicher und eine Recheneinheit. Der Speicher ist notwendig, da die zu verknüpfenden Signale nicht gleichzeitig vorliegen. Das zuerst eintreffende Signal muß daher zunächst gespeichert werden.

Beispielsweise stehen die Sensoren über eine Konzentrationsstufe mit dem Datenverarbeitungssystem in Verbindung. Dort werden aus der Vielzahl der Signale, die bereits konditioniert sein können, nur diejenigen ausgewählt, die für eine Beurteilung des Zustandes des elektrischen Antriebes unbedingt erforderlich sind. Damit wird der Vorteil erzielt, daß dem Datenverarbeitungssystem noch weniger Signale als sonst üblich zugeleitet werden müssen.

Die Sensoren können im übrigen über ein digitales oder hybrides Netzwerk mit dem zentralen oder übergeordneten Datenverarbeitungssystem in Verbindung stehen, was eine zuverlässige Signalübertragung möglich macht.

Mit der Einrichtung nach der Erfindung wird wie auch mit dem Verfahren der Vorteil erzielt, daß mehrere Antriebe gleichzeitig mit einfachen Mitteln on-line überwacht und überprüft werden können, ohne daß die zu überprüfenden Antriebe zur Überprüfung stillgelegt werden müßten. Man kommt dazu mit einfachen Mitteln aus.

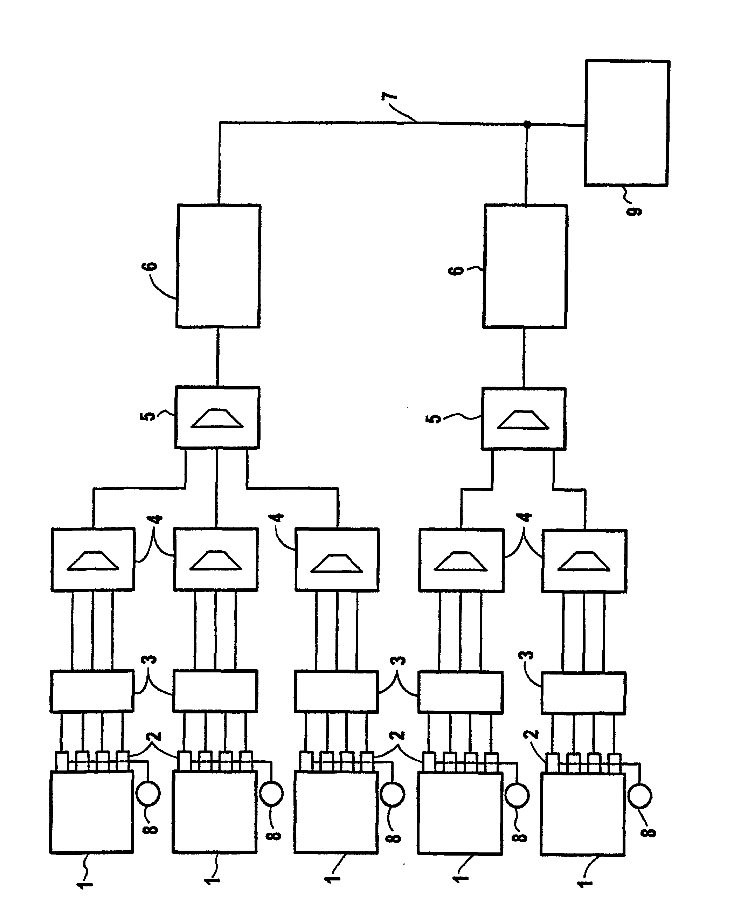

Das Verfahren und die Einrichtung nach der Erfindung zur Überprüfung elektrischer Antriebe werden anhand eines in der Zeichnung dargestellten Ausführungsbeispiels näher erläutert:

In einer Großanlage sind zahlreiche Antriebe 1 vorhanden, die regelmäßig auf ihre Funktionsfähigkeit überprüft werden müssen. Diese Antriebe 1 können elektrische oder elektromagnetische Antriebe sein. Sie können als motorische oder magnetische Antriebe mit Armaturen, Klappen, Steuerventilen, Magnetventilen, Stellgliedern, Schaltschützen und/oder elektrischen Relais verbunden sein. Solche Armaturen usw. sind häufig in Kraftwerken oder Industrieanlagen vorhanden. Die genannten Stellglieder können insbesondere Eisenbahnweichen sein, deren Funktionsfähigkeit regelmäßig überprüft werden muß, um einen sicheren Eisenbahnbetrieb zu gewährleisten.

Jedem elektrischen Antrieb 1 sind mehrere Sensoren 2 zur Aufnahme unterschiedlicher Meßwerte und zur Abgabe von die Meßwerte kennzeichnenden Signalen zugeordnet. Es kann sich bei den Meßwerten beispielsweise um die Stromstärke, die Spannung, die Temperatur usw. handeln. Jeder Sensor 2 steht ausgangsseitig mit einem Signalkonditionierer 3 in Verbindung. Ein solcher Signalkonditionierer 3 kann einen Speicher und eine Recheneinheit enthalten, die nicht gezeigt sind. Im Signalkonditionierer 3 wird aus zwei oder mehr Signalen ein anderes Signal gebildet, das eine andere physikalische Größe darstellt. Auf diese Weise wird die Anzahl der Signale ohne Verlust für die Information verkleinert. Der Signalkonditionierer 3 eines Antriebes 1 steht ausgangsseitig mit einer Konzentrationsstufe 4 in Verbindung. Dort werden aus den ankommenden Signalen nur diejenigen ausgewählt, die den Zustand eines Antriebes 1 besonders zuverlässig zu erkennen gestatten. Die Anzahl der Signale, die ausgewertet werden müssen, wird dadurch vorceilhafterweise weiter eingeschränkt. Für eine Gruppe von mehreren Antrieben 1 ist eine weitere Konzentrationsstufe 5 vorhanden, die die Anzahl der Signale noch weiter verringert. Ausgangsseitig ist die Konzentrationsstufe 5 mit einem zentralen Datenverarbeitungssystem 6 verbunden. Dort sind bereits Sollwerte abgespeichert, mit denen die eintreffenden Signale verglichen werden. Falls Abweichungen festgestellt werden, wird ein Signal an eine räumlich entfernte Anzeigeeinheit 9 oder an eine Steuereinheit, die nicht gezeigt ist, über ein angeschlossenes Netzwerk 7 abgegeben. Falls keine weitere Konzentrationsstufe 5 vorhanden ist, können die Konzentrationsstufen 4 direkt mit dem Datenverarbeitungssystem 6 verbunden sein.

Es kann auch nur ein Datenverarbeitungssystem 6 mehreren Konzentrationsstufen 5 zugeordnet sein. Falls für alle Antriebe 1 nur ein Datenverarbeitungssystem benötigt wird, kann dieses sich auch am Ort der Anzeigeeinheit 9 oder der Steuereinheit befinden.

Die Sensoren 2 sind mit Markiervorrichtungen 8 verbunden, die den Signalen antriebsspezifische Kennzeichen zuordnen. Mit Hilfe dieser Kennzeichen kann im zentralen oder übergeordneten Datenverarbeitungssystem 6 eindeutig festgestellt werden, welcher Antrieb 1 den Anforderungen nicht entspricht, wenn ein konditioniertes und durch eine Konzentrationsstufe 4 ausgewähltes Signal vom Sollwert abweicht.

Mehrere Antriebe können im Betriebszustand gleichzeitig auf ihre Funktionsfähigkeit hin überprüft werden.

## Patentansprüche

1. Verfahren zur Überprüfung einer Mehrzahl elektrischer Antriebe (1), insbesondere von motorischen oder magnetischen Antrieben von Armaturen, Stellgliedern, Schaltschützen oder Relais, wobei an der Mehrzahl elektrischer Antriebe Meßwerte aufgenommen und diese beschreibende Signale dann einem zentralen oder übergeordneten Datenverarbeitungssystem (6) zugeleitet werden, wo sie mit dort vorhandenen Sollwerten verglichen werden und bei einer Abweichung eines Signals von seinem Sollwert ein Fehler desjenigen Antriebes (1), von dem das Signal ausging, angezeigt wird,
**dadurch gekennzeichnet, daß** die Signale mit antriebsspezifischen Kennzeichen versehen und ohne Unterbrechung on-line dem zentralen oder übergeordneten Datenverarbeitungssystem (6) zugeleitet werden, wo durch das antriebsspezifische Kennzeichen ein Fehler demjenigen Antrieb (1) zugeordnet wird, von dem das Signal ausging.

2. Verfahren nach Anspruch 1,
**dadurch gekennzeichnet, daß** die Meßwerte von Sensoren (2) aufgenommen werden, die Leistungskreisen und/oder Steuerungskreisen der Antriebe (1 zugeordnet sind.

3. Verfahren nach einem der Ansprüche 1 oder 2,
**dadurch gekennzeichnet, daß** die Signale, bevor sie dem Datenverarbeitungssystem (6) zugeleitet werden, konditioniert werden.

4. Verfahren nach Anspruch 3,
**dadurch gekennzeichnet, daß** beim Konditionieren Signale zwischengespeichert werden und daß aus diesen und anderen Signalen nicht gemessene physikalische Größen errechnet und diese beschreibende neue Signale bereitgestellt werden.

5. Verfahren nach einem der Ansprüche 1 bis 4,
**dadurch gekennzeichnet, daß** Signale über ein digitales oder hybrides Netzwerk dem zentralen oder übergeordneten Datenverarbeitungssystem zugeleitet werden.

6. Verfahren nach einem der Ansprüche 3 bis 5,
**dadurch gekennzeichnet, daß** die konditionierten Signale konzentriert und erst dann dem Datenverarbeitungssystem (6) zugeleitet werden.

7. Einrichtung zur Durchführung des Verfahrens nach einem der Ansprüche 1 bis 6, wobei an der Mehrzahl elektrischer Antriebe zur Aufnahme von Meßwerten und Abgabe von Signalen Sensoren (2) angeordnet sind, die mit einem zentralen oder übergeordneten Datenverarbeitungssystem (6) verbindbar sind, das eine Vergleichsvorrichtung zum Vergleich der von den Sensoren (2) abgegebenen Signale mit Sollwerten umfaßt und mit einer Anzeigevorrichtung (9) verbunden ist,
**dadurch gekennzeichnet, daß** die Sensoren (2) mit antriebsspezifischen Markiervorrichtungen (8) ausgestattet sind, die die Signale mit antriebsspezifischen Kennzeichen versehen, und daß die Sensoren (2) on-line ohne Unterbrechung mit dem zentralen oder übergeordneten Datenverarbeitungssystem verbunden sind, in dem Signale mit Hilfe der antriebsspezifischen Kennzeichen den Sensoren (2) zuordenbar sind.

8. Einrichtung nach Anspruch 7,
**dadurch gekennzeichnet, daß** Sensoren (2) über mindestens einen Signalkonditionierer (3) mit dem Datenverarbeitungssystem (6) in Verbindung stehen.

9. Einrichtung nach Anspruch 8,
**dadurch gekennzeichnet, daß** jeder Signalkonditionierer (3) einen Speicher und eine Recheneinheit umfaßt.

10. Einrichtung nach einem der Ansprüche 7 bis 9,
**dadurch gekennzeichnet, daß** die Sensoren (2) über eine Konzentrationsstufe (4) mit dem Datenverarbeitungssystem (6) in Verbindung stehen.

11. Einrichtung nach einem der Ansprüche 7 bis 10,
**dadurch gekennzeichnet, daß** die Sensoren (2) über ein digitales oder hybrides Netzwerk mit dem zentralen oder übergeordneten Datenverarbeitungssystem (6) in Verbindung stehen.

## Claims

1. Method for checking a plurality of electric drives (1), in particular motor or magnetic drives of fittings, final control elements, power contactors or relays, wherein measured values are picked up at the plurality of electric drives and signals describing these values are then fed to a central or higher-ranking data-processing system (6) where they are compared with desired values that are available there and if a signal deviates from its desired value an error is indicated for that drive (1) from which the signal originated, **characterized in that** the signals are provided with drive-specific identifiers and are fed without interruption on-line to the central or higher-ranking data-processing system (6) where by means of the drive-specific identifier an error is associated with that drive (1) from which the signal originated.

2. Method according to claim 1, **characterized in that** the measured values are picked up by sensors (2) which are associated with power circuits and/or control circuits of the drives (1).

3. Method according to one of claims 1 or 2, **characterized in that** the signals are conditioned before they are fed to the data-processing system (6).

4. Method according to claim 3, **characterized in that** signals are temporarily stored during the conditioning, and **in that** from these and other signals non-measured physical variables are calculated and new signals describing the latter are made available.

5. Method according to one of claims 1 to 4, **characterized in that** signals are fed to the central or higher-ranking data-processing system by way of a digital or hybrid network.

6. Method according to one of claims 3 to 5, **characterized in that** the conditioned signals are concentrated and only then fed to the data-processing system (6).

7. Device for carrying out the method according to one of claims 1 to 6, wherein arranged at the plurality of electric drives for picking up measured values and emitting signals there are sensors (2) which can be connected to a central or higher-ranking data-processing system (6) which comprises a comparator for comparing the signals emitted by the sensors (2) with desired values and is connected to a display device (9), **characterized in that** the sensors (2) are equipped with drive-specific marking devices (8) which provide the signals with drive-specific identifiers, and **in that** the sensors (2) are connected on-line without interruption to the central or higher-ranking data processing system in which signals can be associated with the sensors (2) with the aid of the drive-specific identifiers.

8. Device according to claim 7, **characterized in that** sensors (2) communicate with the data-processing system (6) by way of at least one signal-conditioner (3).

9. Device according to claim 8, **characterized in that** each signal-conditioner (3) comprises a memory and a computing unit.

10. Device according to one of claims 7 to 9, **characterized in that** the sensors (2) communicate with the data-processing system (6) by way of a concentration stage (4).

11. Device according to one of claims 7 to 10, **characterized in that** the sensors (2) communicate with the central or higher-ranking data-processing system (6) by way of a digital or hybrid network.

## Revendications

1. Procédé pour vérifier une multiplicité d'entraînements électriques (1) en particulier d'entraînements motorisés ou magnétiques de robinets, d'actionneurs, de contacteurs de commutation ou de relais, dans lequel des mesures sont relevées sur une multiplicité d'entraînements électriques et des signaux les décrivant sont ensuite transmis, à un système central ou supérieur hiérarchiquement de traitement des données (6) où ils sont comparés à des valeurs de consigne qui s'y trouvent et dans lequel, en cas de discordance d'un signal avec sa valeur de consigne, un défaut de l'entraînement (1) qui est à l'origine du signal, est indiqué,
**caractérisé en ce que** les signaux sont pourvus de caractéristiques spécifique à l'entraînement et sont transmis en ligne sans interruption au système central ou supérieur hiérarchiquement de traitement des données (6) où, grâce à la caractéristique spécifique à l'entraînement, un défaut est associé à l'entraînement (1) qui est à l'origine du signal.

2. Procédé selon la revendication 1, **caractérisé en ce que** les valeurs mesurées sont reçues par des capteurs (2) qui sont associés à des circuits de puissance et/ou des circuits de commande des entraînements (1).

3. Procédé selon l'une des revendications 1 ou 2, **caractérisé en ce que** les signaux sont conditionnés avant d'être transmis au système de traitement des données (6).

4. Procédé selon la revendication 3, **caractérisé en ce que** lors du conditionnement les signaux sont mémorisés temporairement et on calcule à partir de ceux-ci et d'autres signaux des grandeurs qui ne sont pas mesurées physiquement et que ces nouveaux signaux descriptifs sont mis à disposition.

5. Procédé selon l'une des revendications 1 à 4, **caractérisé en ce que** les signaux sont transmis au système central ou supérieur hiérarchiquement de traitement des données par l'intermédiaire d'un réseau numérique ou hybride.

6. Procédé selon l'une des revendications 3 à 5, **caractérisé en ce que** les signaux conditionnés sont concentrés et que ce n'est qu'alors qu'ils sont transmis au système de traitement des données (6).

7. Dispositif pour réaliser le procédé selon l'une des revendications 1 à 6 pour exécuter le procédé dans lequel, afin de relever les mesures et pour émettre les signaux sur une multiplicité d'entraînements électriques, il est prévu des capteurs (2) qui peuvent être reliés à un système central ou supérieur hiérarchiquement de traitement des données (6) qui comprend un dispositif de comparaison pour comparer les signaux émis par les capteurs (2) avec des valeurs de consigne et qui est relié à un dispositif d'affichage (9),
**caractérisé en ce que** les capteurs (2) sont munis de dispositifs de marquage (8) spécifiques aux entraînements lesquels munissent les signaux de caractéristiques spécifiques aux entraînements et que les capteurs (2) sont connectés en ligne sans interruption avec le système central ou supérieur hiérarchiquement de traitement des données où des signaux peuvent être associés aux capteurs (2) à l'aide des caractéristiques spécifiques aux entraînements.

8. Dispositif selon la revendication 7, **caractérisé en ce que** des capteurs (2) sont reliés au système de traitement des données (6) au moyen d'au moins un conditionneur de signaux (3).

9. Dispositif selon la revendication 8, **caractérisé en ce que** chaque conditionneur de signaux (3) comprend une unité de mémorisation et une unité de calcul.

10. Dispsoitif selon l'une des revendications 7 à 9, **caractérisé en ce que** les capteurs (2) sont reliés au système de traitement des données (6) au moyen d'un étage de concentration (4).

11. Dispositif selon l'une des revendications 7 à 10, **caractérisé en ce que** les capteurs (2) sont reliés au système central ou supérieur hiérarchiquement de traitement des données (6) au moyen d'un réseau numérique ou hybride.
